# EUROPÄISCHE PATENTSCHRIFT

(11) **EP 0 402 566 B1**
(45) Veröffentlichungstag und Bekanntmachung des Hinweises auf die Patenterteilung: **13.12.1995**
(21) Anmeldenummer: 90102831.6
(22) Anmeldetag: 13.02.1990
(51) Int. Cl.: G01R 31/11

(54) **Verfahren und Vorrichtung zur Ortung nicht festbrennbarer Kabelfehler**
Method and device for localising transient arcing cable faults
Procédé et dispositif de localisation des défauts de câbles d'arcs transitoires

(30) Priorität: 15.06.1989 DE 3919497
(43) Veröffentlichungstag der Anmeldung: 19.12.1990
(73) Patentinhaber: Hagenuk KMT Kabelmesstechnik GmbH, 01471 Radeburg (DE)
(72) Erfinder: Lefeldt, Ekkehard, D-2351 Bornhöved (DE)
(74) Vertreter: Hansmann, Dierk, Dipl.-Ing.

(56) Entgegenhaltungen:
- EP-A- 0 062 538
- EP-A- 0 148 674
- DE-A- 2 945 267
- DE-A- 3 711 593
- DE-C- 3 032 519

## Beschreibung

Die Erfindung bezieht sich auf ein Verfahren und eine Vorrichtung zur Ortung nicht festbrennbarer Kabelfehler mittels einer Impulsreflexionsmethode.

Es ist bekannt, um Kabelfehler einer Ortung, insbesondere einer Impulsvorortung zugänglich zu machen, ihren Übergangswiderstand auf die Größenordnung des Kabelwellenwiderstandes zu verringern. Hierzu wird die Fehlerstelle durch elektrische Leistung derart erhitzt, daß sich die Kohlenwasserstoffe der Kabelisolation in leitfähige Kohle umwandeln, oder es wird dafür gesorgt, daß ein elektrischer Lichtbogen stehenbleibt.

Es besteht aber das Problem, daß zahlreiche Kabelfehler nicht festbrennbar sind. Es kommt zwar an der Fehlerstelle zu einem Überschlag und bei genügender Stromabgabe des Brenngerätes auch zu einem Lichtbogen, nach Verlöschen des Lichtbogens ist der Fehler aber sofort wieder hochohmig. Zur Ortung derartiger Fehler ist gemäß DE-B- 22 01 024 ein Verfahren bekannt geworden, bei dem Impulse eines Impulsreflexionsmeßgerätes von einem stehenden Lichtbogen reflektiert werden, der sich wie ein ohmscher Widerstand in der Größenordnung des Kabelwellenwiderstandes verhält. Das Impulsreflexionsmeßgerät wird dabei über einen Hochpaß angekoppelt, der mindestens die wesentlichen Bestandteile des Impulsfrequenzspektrums passieren läßt. Der Lichtbogen muß dabei möglichst konstant gehalten werden. Stromänderungen , die Frequenzanteile beinhalten, die den Hochpaß zum Impulsreflexionsgerät passieren können, müssen vermieden werden. Sie stören oder übersteuern den Verstärker im Impulsreflexionsgerät. Andererseits muß der Lichtbogenstrom so groß sein, daß der Lichtbogenwiderstand in die Größenordnung des Wellenwiderstandes fällt. Das stellt erhebliche Anforderungen an die Leistungsfähigkeit des Brenngerätes, das eine hohe Spannung zum Zünden des Lichtbogens und einen hohen Strom zu seiner Aufrechterhaltung abgeben muß. Der Strom muß dabei durch geeignete Mittel möglichst konstant gehalten werden.

Um die aufzubringende Leistung zu reduzieren, sind Einrichtungen bekannt geworden, bei denen der Lichtbogen nur in Intervallen brennt. Davon wird bei der Einrichtung nach der DE-C-30 32 519 Gebrauch gemacht.

Zur Verbesserung der Energiebilanz bei Kabelfehlerortung mit Stoßspannung ist auch nach der DE-B-20 27 942 ein Verfahren bekannt geworden, bei dem in den Entladekreis des Kondensators eine Induktivität mit einer Freilaufdiode eingeschaltet wird. Hierdurch wird der Strom reduziert und die Entladezeit verlängert.

Weiterhin ist nach der Veröffentlichung Proceedings of the IEE, Vol. 122, No. 4, April 1975, Seiten 403 - 408 bekannt, daß eine Impulsreflexionsdarstellung ohne Fehler (Gesundbild) mit der Impulsreflexionsdarstellung, die den Fehler beinhaltet über elektronische Aufzeichnung mit digitalen Transientenrecordern verglichen wird.

Auch wenn die digitale Signalaufzeichnung heute als ausgereifte Technik angesehen wird, bietet dieses Verfahren erhebliche Nachteile. Durch die bekannte Zündverzögerung beim Eintreffen einer Wellenfront am Kabelfehler kann zur Bestimmung der Fehlerentfernung nicht die Laufzeitdifferenz zwischen Sendestoßimpuls und dem ersten Reflexionsimpuls ausgenutzt werden. Nur die Laufzeit zwischen dem ersten und dem zweiten Reflexionsimpuls (oder jedem weiteren) liefert die exakte Fehlerentfernung.

Der erste Reflexionsimpuls ist aber durch die laufzeitabhängige Dämpfung des Kabels verformt. Bezüglich Kurvenform und Amplitude weicht er von dem Sendeimpuls des Stoßgenerators ab.

Soll zum Vergleich eine Impulsreflexionsdarstellung ohne Fehler (Gesundbild) aufgenommen werden, kann das nur mit dem Sendeimpuls des Stoßgenerators erfolgen, nachdem dessen Ladespannung auf einen Wert eingestellt wurde, der unter der Zündspannung des Fehlers liegt, d.h. zur Gesundbild- und Fehlerbildaufnahme werden Impulse verwendet, die bezüglich Kurvenform und Amplitude stark voneinander abweichen.

Ein exakter Vergleich zwischen Fehlerbild und Gesundbild ist nur möglich, wenn zur Aufzeichnung beider Reflexionsbilder Impulse mit gleicher Kurvenform und Amplitude verwendet werden. Nur in diesem Fall finden an den natürlichen Störstellen eines Kabels die gleichen Reflexionen statt, d.h. die beiden Reflexionsbilder weichen erst an dem Punkt, der den Fehlerort darstellt, voneinander ab und der Fehlerort kann exakt angegeben werden.

Um dieses zu erreichen, ist gemäß der DE-C-30 32 519 ein Verfahren bekannt, bei dem ein Kondensator aufgeladen wird und über eine Funkenstrecke mit nachgeschalteter Induktivität auf die Fehlerstelle entladen wird. Dadurch wird ein Lichtbogen mit einer Brenndauer erzeugt, die es erlaubt, daß ein oder mehrere Impulse eines Impulsreflexionsmeßgerätes reflektiert werden, während nach Abriß des Lichtbogens eine gleich große oder größere Anzahl nicht reflektiert wird.

Die Ankopplung des Impulsreflexionsmeßgerätes erfolgt, wie bereits in der DE-B-22 01 024 angeführt, über einen Hochpaß mit Schutzeinrichtungen, die das Impulsreflexionsgerät vor hohen Spannungen schützen, die bei der Einleitung des Lichtbogens entstehen können.

Derartige Einrichtungen werden als Energietrennfilter bezeichnet und sind relativ aufwendig. Außerdem wird durch das Hochpaßverhalten die Impulsbreite des Reflexionsmeßgerätes nachteilig beeinflußt.

Aus EP-A-0 148 674 ist ein Verfahren zur Ortung von nicht festbrennbaren Kabelfehlern mit einer Impulsreflexionsmethode bekannt. Bei diesem Verfahren wird ein Kondensator auf eine Spannung, die über der Zündspannung der Fehlerstelle liegt, aufgeladen und durch Schließen eines Schalters auf die Fehlerstelle entladen. Die Brenndauer des Lichtbogens wird durch eine in Reihe geschaltete Induktivität zeitlich begrenzt. Kurz nach der Zündung des Lichtbogens, d.h. wenn die an dem Kondensator anliegende Spannung durch den Lichtbogenstrom auf einen Wert unterhalb der Zündspannung des Lichtbogens abgefallen ist, wird mit einem Reflektometer eine Messung an dem Lichtbogen durchgeführt. Dazu wird von dem Reflektometer ein elektrischer Puls auf das Kabel gegeben und die an dem Lichtbogen enstehende Reflexionswelle über eine Koppeleinrichtung einem ersten Kanal eines Speichers zur Aufzeichnung zugeführt. Das Reflektometer ist direkt, d.h. nicht über die Induktivität, mit dem Kabel verbunden. Bei geöffnetem Schalter wird mit dem Reflektometer eine weitere Messung durchgeführt und die Reflexionswelle einem zweiten Kanal des Speichers zur Aufzeichnung zugeführt. Zur Bestimmung des Fehlerortes werden die Aufzeichnungen beider Kanäle des Speichers übereinandergeschrieben. Aus dem Punkt, an dem die beiden Aufzeichnung voneinander abweichen, wird der Fehlerort bestimmt.

Eine Vorrichtung gemäß dem Oberbegriff von Anspruch 2 ist aus der Firmenschrift Baur Information B32 (April 1987) bekannt.

Für diese bekannten Verfahren sind somit immer zwei impulserzeugende Einrichtungen erforderlich. Die erste Einrichtung, um den Lichtbogen zu erzeugen und die zweite Einrichtung im Impulsreflexionsmeßgerät für die Laufzeitmessung.

Weiterhin ist nach der DE-A-29 45 267 ein anderes Verfahren mit einer Differenzmessung zwischen zwei Adern bekannt geworden. Hieraus ist es bekannt, bei einer Vorrichtung zur Ortung von Kabelfehlern mit Stoßspannungen spannungsabhängige Schalter einzusetzen.

Die Aufgabe der Erfindung ist es, ein Verfahren und eine Vorrichtung zu schaffen, die bei Kabelfehlern eine Fehlerortung nur mit einer impulserzeugenden Einrichtung ermöglichen und mit einem Digitalspeicher einen Fehlerbild-Gesundbildvergleich gewährleisten.

Die Lösung dieser Aufgabe hinsichtlich des Verfahrens erfolgt erfindungsgemäß durch ein Verfahren mit den Merkmalen von Anspruch 1. Eine Vorrichtung zur Durchführung des Verfahrens wird durch Anspruch 2 definiert.

Bei dieser Ausbildung besteht der Vorteil, daß ein Energietrennfilter nicht erforderlich ist und die zur Erzeugung beider Reflexionsbilder erforderlichen Impulse gleiche Amplitude und Kurvenform aufweisen.

Eine günstige Ausgestaltung wird dadurch geschaffen, daß der erste Schalter und/oder der zweite Schalter als gesteuerte/r Halbleiterschalter ausgebildet sind/ist. Alternativ wird vorgeschlagen, daß der erste Schalter und/oder der zweite Schalter gesteuerte Funkenstrecken sind/eine gesteuerte Funkenstrecke ist.

Weiterhin wird vorgeschlagen, daß das Begrenzungselement zur Festlegung der Stromflußzeit des Lichtbogens durch eine Induktivität gebildet ist. Als Alternative ist vorgesehen, daß das Begrenzungselement zur Festlegung der Stromflußzeit des Lichtbogens durch einen ohmschen Widerstand gebildet ist.

Zur Fehlererkennung ist weiterhin verfahrensgemäß vorgesehen, daß die Inhalte der beiden Kanäle des Digitalspeichers elektronisch voneinander subtrahiert werden und die Zeitbezogenheit des aus der Subtraktion resultierenden Datenwortes, das einen von Null abweichenden Wert aufweist, zur Bestimmung des Fehlerortes dient.

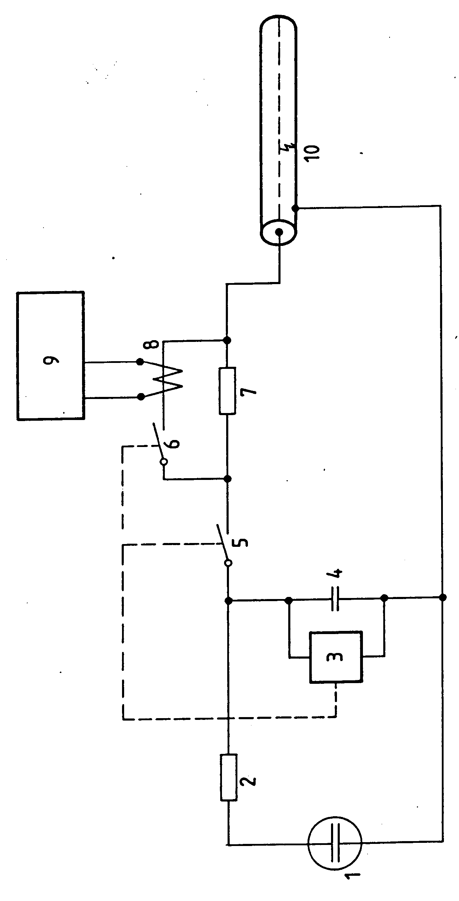

In der Zeichnung ist ein Blockschaltbild als Ausführungsbeispiel der Erfindung schematisch dargestellt.

Hierbei ist eine Gleichspannungsquelle 1 mit ihrem Innenwiderstand 2 zur Ladung eines Kondensators 4 angeschlossen, wobei die Ladespannung über der Überschlagspannung der Fehlerstelle eines Kabels 10 liegt.

Die Leitungsverbindung zum Kabel 10 besitzt einen Schalter 5, über den der Kondensator 4 unter Zwischenschaltung einer Induktivität oder eines ohmschen Widerstandes 7 zur Festlegung der Stromflußzeit eines Lichtbogens auf das Kabel 10 entladen wird. Die Kondensatorspannung wird durch einen zugeordneten Spannungssensor 3 erfaßt. Ist nach dem Schließen des Schalters 5 die Kondensatorspannung auf eine Spannung unter der Zündspannung des Kabels 10 gesunken, wird mittels des Spannungssensors 3 ein Schalter 6 zur Überbrückung des Bauelementes 7 geschlossen und die Restladung des Kondensators 4 impulsartig dem Kabel 10 zugeführt. Die dadurch entstehende Reflexionswelle wird über eine im Überbrückungszweig angeordnete Koppeleinrichtung 8 erfaßt und in einem Kanal eines mit der Koppeleinrichtung 8 verbundenen Digitalspeichers 9 aufgezeichnet.

Anschließend wird der Kondensator 4 erneut geladen, wobei mindestens der Schalter 5 geöffnet wird. Sobald die vorher festgestellte Spannung unterhalb der Zündspannung der Fehlerstelle erreicht ist, wird über den Spannungssensor 3 der Schalter 5 bzw. werden die Schalter 5 und 6 wieder geschlossen. Hierdurch wird der Kondensator 4 auf das Kabel 10 impulsartig entladen. Die dadurch entstehende Reflexionswelle (Gesundbild) wird über die Koppeleinrichtung 8 in einem zweiten Kanal des Digitalspeichers 9 aufgezeichnet.

Durch das Übereinanderschreiben beider ermittelter Speicherbilder wird der entsprechende Fehlerpunkt durch das Aufspreizen der aufgenommenen Kurven kenntlich gemacht und die Fehlerentfernung ist hierdurch genau bestimmbar.

Selbstverständlich kann die Aufzeichnung von Fehlerbild und Gesundbild auf dem Digitalspeicher 9 auch in umgekehrter Reihenfolge durchgeführt werden.

## Patentansprüche

1. Verfahren zur Ortung nicht festbrennbarer Kabelfehler mittels einer Impulsreflexionsmethode, bei der ein Kondensator (4) auf eine über der Zündspannung einer Fehlerstelle im Kabel (10) liegende Spannung aufgeladen und durch Schließen eines Schalters (5) auf die Fehlerstelle entladen wird, wobei ein an der Fehlerstelle brennender Lichtbogen durch ein elektrisches Bauelement (7) zeitlich begrenzt wird, und sobald die Spannung am Kondensator (4) durch den Lichtbogenstrom einen Wert unterhalb der Zündspannung der Fehlerstelle erreicht, die Restladung des Kondensators (4) durch Überbrückung des elektrischen Bauelementes (7) impulsartig dem Kabel (10) zugeführt wird und die dadurch entstehende Reflexionswelle über eine an den Überbrückungspfad angekoppelte Koppeleinrichtung (8) einem ersten Kanal eines Digitalspeichers (9) zur Aufzeichnung zugeführt wird und wobei nach Trennung des Kabels (10) von dem Kondensator (4) mittels des Schalters (5) und erneuter Aufladung des Kondensators (4) auf denjenigen Spannungswert unterhalb der Zündspannung der Fehlerstelle, bei dem die Restladung des Kondensators (4) impulsartig dem Kabel (10) zugeführt wurde, der Kondensator (4) bei überbrücktem elektrischen Bauelement (7) durch Schließen des Schalters (5) erneut auf das Kabel entladen wird, wobei die dabei entstehende Reflexionswelle über die Koppeleinrichtung (8) einem zweiten Kanal des Digitalspeichers (9) zur Aufzeichnung zugeführt wird und anschließend die Aufzeichnungen beider Kanäle des Digitalspeichers (9) derart übereinandergeschrieben werden, daß sich aus dem Punkt, an dem die beiden Aufzeichnungen voneinander abweichen, der Fehlerort bestimmen läßt.

2. Vorrichtung zur Durchführung des Verfahrens nach Anspruch 1, mit einem aufladbaren Kondensator (4), einem elektrischen Bauelement (7) zur zeitlichen Begrenzung eines Lichtbogens, der an einer Fehlerstelle eines einen nicht festbrennbaren Kabelfehler aufweisenden Kabels (10) brennt, einem Speicher (9) mit zwei Kanälen zur jeweiligen Aufzeichnung von im Kabel (10) entstehenden Reflexionswellen bei brennendem und nicht brennendem Lichtbogen, wobei die Aufzeichnungen der beiden Kanäle übereinandergeschrieben werden können, einer mit dem Eingang des Speichers (9) verbundenen Koppeleinrichtung (8) zur Übertragung der durch einen Strompfad laufenden Reflexionswellen, einem ersten (5) und einem zweiten Schalter (6), wobei der erste Schalter (5) einen Anschluß des Kondensators (4) über das in Serie geschaltete elektrische Bauelement (7) mit dem Leiter des Kabels (10) verbindet und der zweite Schalter (6) in einem zum elektrischen Bauelement (7) parallelgeschalteten Strompfad liegt, dadurch gekennzeichnet, daß der Speicher (9) ein Digitalspeicher ist, daß die Koppeleinrichtung (8) an den dem elektrischen Bauelement (7) parallelgeschalteten Strompfad derart angekoppelt ist, daß sie nur die durch diesen Strompfad laufenden wellenüberträgt, daß ein Spannungssensor (3) die Spannung über dem Kondensator (4) erfaßt und daß die Schalter (5, 6) über den Spannungssensor (3) derart steuerbar sind, daß nach dem Erzeugen eines Lichtbogens bei geschlossenem ersten Schalter (5) der zweite Schalter (6) bei einer Spannung unterhalb der Zündspannung der Fehlerstelle geschlossen wird und durch Überbrücken des elektrischen Bauelementes (7) den Kondensator (4) impulsartig auf das Kabel (10) entlädt und daß nach Öffnen des ersten Schalters (5) und anschließender Aufladung des Kondensators (4) auf die gleiche Spannung unterhalb der Zündspannung der Fehlerstelle die Schalter (5, 6) zur Entladung des Kondensators (4) auf das Kabel (10) geschlossen werden.

3. Vorrichtung nach Anspruch 2, dadurch gekennzeichnet, daß der erste Schalter (5) und/oder der zweite Schalter (6) als gesteuerte/r Halbleiterschalter ausgebildet sind/ist.

4. Vorrichtung nach Anspruch 2, dadurch gekennzeichnet, daß der erste Schalter (5) und/oder der zweite Schalter (6) gesteuerte Funkenstrecken sind/eine gesteuerte Funkenstrecke ist.

5. Vorrichtung nach einem der Ansprüche 2 bis 4, dadurch gekennzeichnet, daß das Begrenzungselement (7) zur Festlegung der Stromflußzeit des Lichtbogens durch eine Induktivität gebildet ist.

6. Vorrichtung nach einem der Ansprüche 2 bis 4, dadurch gekennzeichnet, daß das Begrenzungselement (7) zur Festlegung der Stromflußzeit des Lichtbogens durch einen ohmschen Widerstand gebildet ist.

7. Verfahren nach Anspruch 1, bei dem die Inhalte der beiden Kanäle des Digitalspeichers (9) elektronisch voneinander subtrahiert werden und die Zeitbezogenheit des aus der Subtraktion resultierenden Datenwortes, das einen von Null abweichenden Wert aufweist, zur Bestimmung des Fehlerortes dient.

## Claims

1. Method of locating cable faults which cannot be permanently short-circuited by means of a pulse-reflection method in which a capacitor (4) is charged to a voltage situated above the ignition voltage of a faulty position in the cable (10) and is discharged across the faulty position by closing a switch (5), an arc struck at the faulty position being time-limited by an electrical component (7), and as soon as the voltage across the capacitor (4) reaches a value below the ignition voltage of the faulty position as a result of the arc current, the residual charge of the capacitor (4) is fed to the cable (10) in pulse form by bypassing the electrical component (7) and the reflection wave thereby produced is fed for the purpose of recording via a coupling device (8) coupled to the bypass path to a first channel of a digital memory (9), and in which process, after isolating the cable (10) from the capacitor (4) by means of the switch (5) and recharging the capacitor (4) to that voltage value below the ignition voltage of the faulty position at which the residual charge of the capacitor (4) is fed to the cable (10) in pulse form, the capacitor (4) is again discharged across the cable with electrical component (7) bypassed by closing the switch (5), the reflection wave produced in this process being fed for the purpose of recording via the coupling device (8) to a second channel of the digital memory (9) and the recordings of both channels of the digital memory (9) then being overwritten on one another so that the fault position can be determined from the point at which the two recordings deviate from one another.

2. Apparatus for performing the method according to Claim 1, comprising a chargeable capacitor (4), an electrical component (7) for time-limiting an arc which is struck at a faulty position in a cable (10) having a cable fault which cannot be permanently short-circuited, a memory (9) comprising two channels for the respective recording of reflection waves produced in the cable (10) in the case of a striking and non-striking arc, it being possible to overwrite the recordings of the two channels on one another, a coupling device (8) connected to the input of the memory (9) for the purpose of transmitting the reflection waves travelling through a current path, a first switch (5) and a second switch (6), the first switch (5) connecting a terminal of the capacitor (4) via the series-connected electrical component (7) to the conductor of the cable (10) and the second switch (6) being situated in a current path connected in parallel with the electrical component (7), characterized in that the memory (9) is a digital memory, in that the coupling device (8) is coupled to the current path connected in parallel with the electrical component (7) in such a way that it transmits only the waves travelling through said current path, in that a voltage sensor (3) measures the voltage across the capacitor (4), and in that the switches (5, 6) can be controlled by means of the voltage sensor (3) in such a way that, after generating an arc with first switch (5) closed, the second switch (6) is closed at a voltage below the ignition voltage of the faulty position and discharges the capacitor (4) in pulse form across the cable (10) by bypassing the electrical component (7) and so that, after opening the first switch (5) and subsequently charging the capacitor (4) to the same voltage below the ignition voltage of the faulty position, the switches (5, 6) are closed for the purpose of discharging the capacitor (4) across the cable (10).

3. Apparatus according to Claim 2, characterized in that the first switch (5) and/or the second switch (6) are/is constructed as controllable semiconductor switch(es).

4. Apparatus according to Claim 2, characterized in that the first switch (5) and/or the second switch (6) are controlled spark gaps/is a controlled spark gap.

5. Apparatus according to one of Claims 2 to 4, characterized in that the limiting element (7) for determining the current flow time of the arc is formed by an inductance.

6. Apparatus according to one of Claims 2 to 4, characterized in that the limiting element (7) for determining the current flow time of the arc is formed by an ohmic resistor.

7. Method according to Claim 1, in which the contents of the two channels of the digital memory (9) are subtracted electronically from one another and the time reference of the data word resulting from the subtraction, which word has a value deviating from zero, is used to determine the faulty position.

## Revendications

1. Procédé de localisation de défauts d'arcs transitoires dans des câbles à l'aide d'une méthode par réflexion d'impulsions dans lequel un condensateur (4) est chargé à un potentiel plus élevé que la tension de claquage d'un défaut du câble (10) et est déchargé dans le défaut par la fermeture d'un contact (5) y amorçant un arc électrique dont la durée est limitée par un composant électrique (7) et, dès que le potentiel du condensateur (4) diminue, sous l'effet du courant dans l'arc, au-dessous de la tension de claquage du défaut de câble, la charge résiduelle du condensateur (4) est libérée dans le câble, sous forme d'une impulsion, par pontage du composant électrique (7), l'onde réfléchie ainsi créée étant dirigée à travers un élément de couplage (8), raccordé au niveau du pontage, vers la première voie d'une mémoire numérique (9) d'enregistrement; et dans lequel après la séparation du câble (10) du condensateur (4) par l'interrupteur (5) et par conséquence une nouvelle charge du condensateur (4) au potentiel au-dessous de la tension de claquage qui correspond à la charge résiduelle du condensateur (4) qui a été libérée dans le câble (10) sous forme d'impulsion, le condensateur (4) est à nouveau déchargé dans le câble (10), à travers le composant électrique (7) ponté, par la fermeture du contact (5), l'onde réfléchie créée étant dirigée pour enregistrement sur une deuxième voie de la mémoire numérique (9) à travers l'élément de couplage (8), la superposition des traces des deux voies de l'enregistreur numérique (9) permettant de localiser l'endroit du défaut au point où les deux enregistrements sont dissemblables.

2. Dispositif de mise en oeuvre du procédé selon revendication 1 qui comprend, un condensateur chargeable (4), un composant électrique (7) de limitation dans le temps d'un arc électrique transitoire qui s'établit à l'endroit d'un défaut d'un câble (10), une mémoire (9) à deux voies d'enregistrement des ondes réfléchies par le câble (10), la première correspondant à l'arc allumé la seconde à l'arc éteint, les enregistrements des deux voies pouvant être superposés, un élément de couplage (8) de transmission des ondes réfléchies dans un circuit électrique, un premier (5) et un deuxième interrupteur (6), le premier interrupteur (5) connectant un pôle du condensateur (4) au conducteur du câble (10) à travers le composant électrique (7) connecté en série, le second interrupteur (6) étant branché en dérivation du composant électrique (7), caractérisé par les faits que la mémoire (9) est une mémoire numérique, que le dispositif de couplage (8) au circuit électrique branché en dérivation du composant électrique (7), y est couplé de telle façon à ne transmettre que les ondes qui parcourent ce circuit, qu'un capteur de tension (3) mesure la tension aux bornes du condensateur et que les interrupteurs (5, 6) peuvent être pilotés par le capteur de tension (3) de telle sorte qu'après amorçage d'un arc, le premier interrupteur (5) étant fermé, le deuxième interrupteur (6) est fermé lorsque la tension tombe au-dessous de la tension de claquage du défaut du câble et que par le pontage du composant électrique (7) le condensateur (4) est déchargé rapidement dans le câble (10) et qu'après ouverture du premier interrupteur (5) et la charge consécutive du condensateur (4) au même potentiel, au-dessous de la tension de claquage à l'endroit du défaut, les interrupteurs (5, 6) sont fermés pour décharger le condensateur (4) dans le câble (10).

3. Dispositif selon revendication 2, caractérisé par le fait que le premier interrupteur (5) et/ou le second interrupteur (6) est ou sont du type commutateur pilotable à semi-conducteurs.

4. Dispositif selon revendication 2, caractérisé par le fait que le premier interrupteur (5) et/ou le second interrupteur (6) est ou sont du type pont d'éclatement pilotable.

5. Dispositif selon une des revendications 2 à 4, caractérisé par le fait que l'élément électrique (7) de limitation de la durée de l'arc est une self.

6. Dispositif selon une des revendications 2 à 4, caractérisé par le fait que l'élément électrique (7) de limitation de la durée de l'arc est une résistance ohmique.

7. Procédé selon la revendication 1, dans lequel le contenu des deux voies de la mémoire numérique (9) est soustrait l'un de l'autre par moyen électronique et que la relation temporelle du message résultant de la soustraction et différent de zéro est utilisée pour localiser l'endroit du défaut.
